(19) Europäisches Patentamt
European Patent Office
Office européen des brevets

(11) **EP 2 223 132 B1**

(12) **EUROPÄISCHE PATENTSCHRIFT**

(45) Veröffentlichungstag und Bekanntmachung des Hinweises auf die Patenterteilung:
**13.06.2018 Patentblatt 2018/24**

(21) Anmeldenummer: **08852554.8**

(22) Anmeldetag: **30.09.2008**

(51) Int Cl.:
*G01R 31/36* *(2006.01)*     *H01M 10/06* *(2006.01)*
*H01M 10/48* *(2006.01)*

(86) Internationale Anmeldenummer:
**PCT/EP2008/063049**

(87) Internationale Veröffentlichungsnummer:
**WO 2009/065656 (28.05.2009 Gazette 2009/22)**

(54) **ERMITTLUNG DER KAPAZITÄT ELEKTRISCHER ENERGIESPEICHER**

DETERMINING THE CAPACITY OF ELECTRICAL ENERGY STORAGE SYSTEMS

DÉTERMINATION DE LA CAPACITÉ D'ACCUMULATEURS D'ÉNERGIE ÉLECTRIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **20.11.2007 DE 102007055255**

(43) Veröffentlichungstag der Anmeldung:
**01.09.2010 Patentblatt 2010/35**

(73) Patentinhaber: **Robert Bosch GmbH**
**70442 Stuttgart (DE)**

(72) Erfinder:
• **SCHOCH, Eberhard**
  **70469 Stuttgart-Feuerbach (DE)**
• **ISKE, Burkhard**
  **71272 Renningen-Malmsheim (DE)**

(56) Entgegenhaltungen:
**EP-A- 1 343 017     WO-A-03/005052**
**DE-A1- 19 918 529**

## Beschreibung

### Stand der Technik

Die Erfindung geht aus von einem Verfahren zur Erfassung der Ladung, die einem Energiespeicher noch entnehmbar ist. Es sind verschiedene Verfahren zur Bestimmung der verfügbaren Kapazität und somit der entnehmbaren Ladung eines elektrischen Energiespeichers bekannt, insbesondere für Batterien, die als Starterbatterien in Kraftfahrzeugen verwendet werden, d.h. für Bleiakkumulatoren.

In der Druckschrift DE 10236958 A1 ist ein Verfahren beschrieben, das die verfügbare Kapazität aus dem Einschwingverhalten der Batteriespannung bei einem definierten Belastungsimpuls ermittelt. In dieser Druckschrift ist ferner ein Verfahren zur Bestimmung der verfügbaren Kapazität in einer Speicherbatterie beschrieben, wobei das Verfahren aus der Spannungsantwort eine Widerstandsänderung bzw. einen Differenzwiderstand berechnet, der sich durch definierte, zeitlich aufeinander folgende Strompulse ergibt. Dieser Widerstandsänderung ist ein Wert für die verfügbare Kapazität zugeordnet. Die Druckschrift DE 102 32 251 A1 beschreibt ebenfalls ein Ladungsermittlungsverfahren, das auf der Beurteilung von Spannungsantworten auf Belastungspulse basiert.

Weiterhin sind Verfahren bekannt, in denen verfügbare Kapazitäten durch Beobachtung des Innenwiderstands während einer Entladung bestimmt werden, wobei ein Effekt berücksichtigt wird, demgemäß der Innenwiderstand bei Unterschreiten eines Füllstands von 50 % deutlich ansteigt. Die oben beschriebenen Verfahren erfordern einen aktiven Eingriff, um die Impulsantworten zu erzeugen, und weisen eine geringe Genauigkeit auf.

In der Druckschrift DE 10301823 A1 ist ein Verfahren beschrieben, das die entnehmbare Ladung mit Hilfe eines Prädiktionsmodells bzw. Schätzmodells des Energiespeichers schätzt bzw. vorausberechnet, dessen Zustandsgrößen und Betriebsparameter kontinuierlich an die Werte der realen Batterie mittels eines Batteriemodells adaptiert werden. Als Faktoren, die die aktuell verfügbare Kapazität definieren, werden die aktuelle Batterietemperatur, der Entladestrom sowie der irreversible Kapazitätsverlust durch Alterung berücksichtigt. Der bisherige Betrieb bzw. die bisherigen Betriebsbedingungen werden bei dieser Berechnung nicht berücksichtigt. Dadurch ist das in DE 10301823 A1 beschriebene modellbasierte Verfahren ungenau, insbesondere bei zunehmender Alterung.

Aus der WO-A 03/005052 ist ein Verfahren zur Ermittlung des Ladezustands und/oder der Leistungsfähigkeit eines Ladungsspeichers bekannt, das unter Verwendung von Abschätzungen arbeitet, wobei bei den Abschätzungen Informationen, die bei wenigstens zwei unterschiedlichen Betriebspunkten oder Betriebsbedingungen des Energiespeichers gewonnen werden, berücksichtigt werden. Die Abschätzungen erfolgen hinsichtlich eines aktuellen und/oder eines künftigen Ladezustands und/oder einer aktuellen und/oder künftigen Leistungsfähigkeit des Ladungsspeichers. Je nach Betriebspunkt bzw. Betriebsbedingungen werden unterschiedliche Verfahren abgearbeitet.

### Offenbarung der Erfindung

Die Erfindung erlaubt eine präzise Erfassung der entnehmbaren Ladungsmenge eines Akkumulators, in dem die entnehmbare Ladungsmenge mittels eines Faktors aus dem Gesamtkapazitäts-Schätzwert berechnet wird. Der Faktor berücksichtigt erfindungsgemäß Auswirkungen auf die Ladungsmenge, die auf die Temperatur während der Entladung zurückgehen. Mit anderen Worten werden temperaturabhängige Prozesse beim Entladen berücksichtigt, indem Fehler berücksichtigt werden, die auf Temperaturdifferenzen beruhen. Derartige Temperaturdifferenzen treten insbesondere in Fahrzeugen, bsp. Hybridfahrzeugen auf. Erfindungsgemäß umfasst somit der Faktor eine Kompensationskomponente, die sich auf einen Temperaturfehler bezieht, der sich ergibt, wenn die Auswirkungen der Entladetemperatur nicht berücksichtigt werden. Erfindungsgemäß wird daher die Gesamtkapazität als Gesamtkapazitäts-Schätzwert ( = Schätzung des Gesamtspeichervolumens der Batterie) vorgesehen, der mit einem Verhältnis einer ersten Ruhespannungsdifferenz zu einer zweiten Ruhespannungsdifferenz multipliziert wird. Die erste Ruhespannungsdifferenz ergibt sich aus der aktuellen Ruhespannung der Batterie abzüglich der Minimal-Ruhespannung der Batterie, die sich auf diejenige Betriebstemperatur bezieht, die während des Entladens der Batterie geherrscht hat. Die zweite Ruhespannungsdifferenz ergibt sich aus der aktuellen Maximal-Ruhespannung der Batterie und der Minimal-Ruhespannung der Batterie, die sich auf die Betriebsspannung bezieht, die während der Entladung, d.h. während des Betreibens der Batterie als elektrische Energiequelle geherrscht hat. Die Ruhespannung ist die Batteriespannung bei einem Strom von 0 A, wenn die Batterie im thermodynamischen Gleichgewicht ist, d.h. beispielsweise nach einer Mindestruhepause nach der letzten Belastung. Die Minimal-, Maximal- und aktuelle Ruhespannung ist die Ruhespannung bei minimaler, maximaler und aktueller entnehmbarer Ladungsmenge.

Es sind somit keine aktiven Eingriffe in den Betrieb der Batterie notwendig. Gleichzeitig ergeben sich deutlich genauere Schätzungen der entnehmbaren Ladungsmenge, auch wenn signifikante Änderungen der Batterieeigenschaften eingetreten sind, beispielsweise durch Alterung, Temperaturerhöhung oder Temperaturverringerung.

Erfindungsgemäß wird daher, im Gegensatz zum Stand der Technik, der real messbare Einfluss der Vorgeschichte der Batterie berücksichtigt, d.h. die Vorgeschichte der Batterietemperatur, um die verfügbare Kapazität und die verfügbare Ladungsmenge bzw. den Ladezustand, d.h. die entnehmbare Ladungsmenge, zu erfassen. Erfindungsgemäß wird somit berücksichtigt, dass man beispielsweise unterschiedliche Restkapazitäten bei einer auf Tbatt1 temperierten vollgeladenen und anschließend um eine definierte Ladungsmenge entladenen Batterie misst, gegenüber einer Batterie gleichen Typs, die bei einer anderen Temperatur Tbatt2 ausgehend vom Vollladezustand um die gleiche Ladungsmenge entladen und anschließend auf Tbatt1 temperiert wurde. Das Verhältnis der Restkapazität zur Gesamtkapazität der Batterie (=Ladezustand bei aktueller Temperatur) bleibt dabei bei veränderlichen Temperaturen nahezu konstant.

Der Grund für dieses Verhalten erklärt sich aus der Temperaturempfindlichkeit der Säurediffusion und der Größe der gebildeten Sulfatkristalle. Bei Entladungen, die bei tiefen Temperaturen stattfinden, werden aufgrund der eingeschränkten Säurediffusion vorwiegend äußere Bereiche der Elektroden in nicht leitendes Bleifsulfat umgesetzt, und die Poren der Elektroden werden durch grobkörnige Sulfatkristalle bedeckt. Dadurch können die inneren Bereiche der Elektrode nicht mehr an der Entladereaktion teilnehmen. Eine anschließende Erwärmung der Batterie ändert daran nichts, da sich die Festkörper (d.h. Elektrodenkörper) bereits gebildet haben, so dass die Restkapazität bei der höheren Temperatur kleiner ist, als wenn die Batterie von vorne herein bei der höheren Temperatur entladen worden wäre.

Der Kapazitätsverlust kann jedoch größtenteils durch Vollladen der Batterie wieder aufgehoben werden, da dadurch das passivierte grobkörnige Bleisulfat auf der Elektrodenoberfläche wieder in Blei bzw. Bleidioxid umgesetzt wird, wodurch sich der oben beschriebene Festkörper mit nachteiliger Struktur wieder auflöst. Daher ist der Kapazitätsverlust, der auftritt, wenn die Batterie bei tiefen Temperaturen entladen wird, reversibel.

Die Erfindung berücksichtigt diese Vorgänge durch Anwendung von Modellen, die sich durch die folgenden Gleichungen ausdrücken lassen.

$$Qe, akt = C0 \cdot (U0,akt - U0,min),$$

wobei gilt:

Qe,akt: aktuell entnehmbare Ladung eines Energiespeichers;
C0: Säure- oder Ersatzkapazität der Batterie;
U0,akt: aktuelle Ruhespannung;
U0,min: minimale Ruhespannung der entladenen Batterie.

U0,min ist abhängig von Tbatt, Ibatt und ALT, wobei gilt:

Tbatt: aktuelle Batterietemperatur
Ibatt: Entladestrom und
ALT: Alterungsparameter.

Die minimale Ruhespannung, U0,min, ist die Ruhespannung einer Batterie in thermodynamischen Gleichgewicht, die sich beim Entladen bei einem konstanten, vorgegebenen Entladestrom ergibt, oder bei einem Entladestrom ergibt, der über während des gesamten Entladens nicht unter einen Minimal-Grenzwert fällt, wobei das Entladen beim Erreichen einer Entladeschlussspannung (bsp. 10.5V, d.h. Einzelzellspannung = 1,75V) beendet und das Ende eines Ausgleichsvorgangs, d.h. das thermische Gleichgewicht, abgewartet wird.

Die Säuremenge CO ist ein Maß für die Säuremenge in der Batterie, während die Ruhespannung U0,akt ein Maß für die aktuelle Säurekonzentration ist. Die minimale Ruhespannung U0,min ist ein Maß für die Säurekonzentration im Entladeschluss, d.h., wenn einer der Reaktionspartner (Säure oder Aktivmasse) für die Entladereaktion nicht mehr ausreichend zur Verfügung steht. Da die Säuremenge, die für die Entladereaktion in den Poren der Elektroden zur Verfügung steht, stark von der Säurediffusion aus dem Elektrolyten abhängt, die wiederum temperatur- und entladestromabhängig ist, ist auch U0,min temperatur- und entladestromabhängig. Ferner verschiebt sich U0,min mit zunehmendem Aktivmasseverlust oder mit zunehmender Sulfatierung bei Batteriealterung zu höheren Werten. Die Alterungsparameter sind somit beispielsweise Aktivmasseverlust und Sulfatierung.

Die maximal entnehmbare Ladung, die der gesamten Kapazität der Batterie entspricht, Qe,max, ergibt sich aus der obigen Formel U0,akt, wenn der Maximalwert U0,max eingesetzt wird:

$$Qe,max = C0 \cdot (U0,max - U0min,akt).$$

U0,max ist die Batteriespannung im thermischen Gleichgewicht, die sich nach oder bei vollständiger Ladung der Batterie ergibt.

Wie auch für die oben definierte Ladung Qe,akt gilt für Qe,max, dass diese von Tbatt, Ibatt und ALT abhängt. Ebenso ist U0,min von Tbatt, Ibatt und ALT abhängig.

Hierbei ist U0,max ein Maß für die Säurekonzentration der vollgeladenen Batterie und kann durch Alterungseffekte wie Wasserverlust oder Sulfatierung über oder unter dem Wert einer neu hergestellten Batterie liegen.

Gemäß dem Einfluss der Vorgeschichte, d.h. der Temperatur, bei der die Batterie vorher entladen wurde, der im Stand der Technik unberücksichtigt bleibt, hängt erfindungsgemäß die verfügbare Kapazität bei der aktuellen Temperatur davon ab, bei welcher Temperatur die Batterie zuvor entladen wurde. Dadurch wird die Temperaturabhängigkeit der Säurediffusion und die Größe der gebildeten Sulfatkristalle, die beide von der Temperatur abhängen, berücksichtigt. Das Verhältnis der verfügbaren Ladung zur Gesamtkapazität bei der aktuellen Temperatur (d.h. der relative Ladezustand bei der aktuellen Temperatur) ist nahezu temperaturabhängig, so dass bei zwei verschiedenen Temperaturen Tbatt1, Tbatt2 für die Ladung bzw. Kapazität gilt:

$$(1) \quad Qe(Tbatt2) \,/\, Qe,max(Tbatt2) = Qe(Tbatt1) \,/\, Qe,max \,(Tbatt1).$$

Es gilt:

Qe: entnehmbare Ladung, d.h. verfügbare Ladung;
Qe,max: Gesamtkapazität.

Es wird bei der Ermittlung von U0,min angenommen, dass der Entladestrom Ibatt und die Entladeschlussspannung Ubatt,min konstant sind. Beispielsweise kann angenommen werden, dass Ibatt = 20 A ist, und Ubatt,min = 10,5 V beträgt.

Aus der Gleichung (1) folgt dann mit Tbatt2 = Tbatt (aktuelle Temperatur), und Tbatt1 = 25 °C (Entladetemperatur):

$$Qe,akt \,(Tbatt) = (Qe \,(25\ °C) \,/\, Qe,max \,(25\ °C) \cdot Qe,max,akt \,(Tbatt).$$

Die Temperatur 25 °C ist als ein Beispiel gewählt und steht für die Temperatur, bei der die Batterie entladen wurde. Statt 25 °C kann auch eine Variable Tbatt,entl verwendet werden, die für die Temperatur steht, die in der Batterie und somit auch an den Elektroden während des vorhergehenden Entladevorgangs geherrscht hat.

Durch Einsetzen von Qe,akt = U0,akt - U0,min (Tbatt,entl) und durch Einsetzen von Qe,max (Tbatt,entl) = U0,max - U0,min (Tbatt,entl) ergibt sich:

$$(2) \quad Qe(Tbatt) = [(U0,akt - U0,min(Tbatt,entl)) \,/\, (U0,max - U0,min(Tbatt,entl))] \cdot Qe,max$$

Somit kann die aktuell entnehmbare Ladung Qe,akt bei der aktuellen Temperatur Tbatt gemäß Gleichung (2) durch Skalierung der maximal entnehmbaren Ladung Qe,max bei der aktuellen Temperatur Tbatt mit dem Verhältnis der Differenz von Ruhespannung und deren Minimalwert bezogen auf die maximale Ruhespannungsdifferenz bei der Entladetemperatur Tbatt,entl, beispielsweise 25 °C, berechnet werden.

Die Gesamtkapazität der Batterie Qe,max bei der aktuellen Temperatur Tbatt ist unabhängig von der Vorgeschichte der Batterie hinsichtlich der Temperatur, da der durch die Temperatur verursachte Kapazitätsverlust reversibel ist. Aus diesem Grund kann die aktuelle (oder eine auf die Entladetemperatur bezogene) Gesamtkapazität der Batterie wie bisher mit einem geeigneten Verfahren berechnet werden. Erfindungsgemäß ist ein geeignetes Verfahren zur Berechnung der Gesamtkapazität in der Druckschrift DE 10301823 A1 beschrieben, und betrifft ein Verfahren zum Ermitteln der aus einem Energiespeicher entnehmbaren Ladung mittels eines Prädiktionsmodells, das an die reale Batterie adaptiert ist. Als Zustandsgröße muss in dem in DE 10301823 A1 beschriebenen Verfahren die Gesamtkapazität aufgenommen werden oder vorgesehen sein, die gemäß dem zugrunde liegenden mathematischen (oder empirischen Modell) mit denjenigen Zustandsgrößen verknüpft ist, die in dem Verfahren von DE 10301823 A1 als Zustandsgrößen verwendet werden. In gleicher Weise kann als Zustandsgröße auch U0,akt, U0,max und/oder U0,min (Tbatt,entl) vorgesehen werden.

U0,akt kann durch Messung der Klemmenspannung im lastfreien, thermodynamisch eingeschwungenen Zustand der Batterie im aktuellen Zustand erfasst werden. Ferner ist U0,akt im wesentlichen proportional zur Säurekonzentration in den Zellen. Daher kann U0,akt erfasst werden durch Messen der Klemmenspannung, nachdem sich der gewünschte eingeschwungene Zustand eingestellt hat, beispielsweise nach einer Ruhephase, und/oder durch Erfassen bzw. Ermitteln der Säurekonzentration der Batterie, beispielsweise durch pH-Wert-Messungen oder durch (empirische) Modelle, die zur Ermittlung der Säurekonzentration aus anderen Größen (Strom/Spannung/Innenwiderstand) geeignet sind. In gleicher Weise lassen sich U0,max und U0,min erfassen, wobei jedoch die Batterie bei der Erfassung von U0,akt vollgeladen ist, und die Batterie bei der Erfassung von U0,min bis zur Entladeschlussspannung Ubatt,min entladenen ist. Wie oben bemerkt, wird hierzu beispielsweise die Klemmenspannung im lastfreien, thermodynamisch eingeschwungenen Zustand der Batterie erfasst, beispielsweise nach einer Ruhephase (= Zeitintervall mit einer Mindestlänge, das sich direkt an die letzte Belastung der Batterie anschließt).

Alternativ kann jedes geeignete Schätzverfahren zur Schätzung der aktuellen Gesamtkapazität der Batterie verwendet werden, das sich an Messgrößen, Zustandsgrößen und/oder Modellen orientiert. Zur Schätzung der Gesamtkapazität können Look-up-Tabellen oder Näherungsgleichungen verwendet werden, die auf empirischen Daten oder auf physikalischen Modellen basieren. Da, wie oben bemerkt, die Gesamtkapazität nicht durch die Temperatur des vorherigen Entladevorgangs beeinflusst wird, kann eine Vielzahl von Modellen verwendet werden, ohne die Genauigkeit des erfindungsgemäßen Verfahrens zu beeinträchtigen.

Als Zustandsgrößen oder Messgrößen können Entladestrom, Entladespannung, Leerlaufspannung, Kurzschlussstrom und/oder Temperatur verwendet werden, um aus diesen Größen auf die aktuelle Gesamtkapazität der Batterie zu schließen. Ferner können auch aktive Messmechanismen verwendet werden, bei denen die Reaktion auf Storm bzw. Spannungsimpulse verwendet wird, um die Gesamtkapazität der Batterie zu schätzen. Alternativ oder in Kombination hierzu kann der Lade- bzw. Entladestrom kontinuierlich erfasst und integriert werden, um aus der so dargestellten Ladungsbilanz und der Gesamtladung, die bei einem vorherigen Ladevorgang geflossen ist, die Gesamtkapazität der Batterie zu ermitteln. Es können auch vorbestimmte bzw. gespeicherte Werte verwendet werden.

Die Gesamtkapazität kann ferner mittels Prädiktionsmodellen erfasst werden, die auch zur Ermittlung weiterer Größen verwendet werden, die in dem erfindungsgemäßen Verfahren verwendet werden (bspw. U0,max, U0,min, U0,akt). Ferner sind Kalman-Filter, neuronale Netze oder Expertensysteme zur Ermittlung der Gesamtkapazität möglich, die Betriebsparameter der Batterie verfolgen, gegebenenfalls regelmäßig abgleichen und mit denen sich die Gesamtkapazität schätzen lässt.

Ferner kann die Gesamtkapazität damit vorgesehen werden, indem die Differenz zwischen der aktuellen Maximal-Ruhespannung der Batterie und der aktuellen Minimal-Ruhespannung der Batterie ermittelt wird, und diese Differenz mit einem Säurekapazitäts-Wert (bspw. eine Zustandsgröße eines der oben genannten Modelle) der Batterie multipliziert wird. Die aktuelle Maximal-Ruhespannung U0,max und die aktuelle Minimal-Ruhespannung U0,min der Batterie kann durch Messungen und/oder durch eines der oben genannten Schätzverfahren vorgesehen werden, beispielsweise mittels Prädiktionsverfahren, die auf Batteriemodellen basieren, wie sie oben beschrieben sind.

Ferner wird die aktuelle Ruhespannung U0,akt der Batterie und die Minimal-Ruhespannung der Batterie bei der Betriebstemperatur mittels eines Adaptionsverfahrens, mittels eines modellgestützten Adaptionsverfahrens, mittels eines Kalman-Filters, mittels einer Look-up-Tabelle, mittels Näherungsgleichungen oder mittels selbstlernenden Schätzern in Form neuronaler Netze bestimmt werden, vorzugsweise mittels eines modellgestützten Adaptionsverfahrens bzw. Kalman-Filters, wie es in DE 10301823 A1 beschrieben ist. In diesem Fall wird, wie dort beschrieben, der Betrieb der Batterie verfolgt und die aktuelle Ruhespannung sowie die Minimal-Ruhespannung der Batterie bei Betriebstemperatur ermittelt, indem die jeweiligen Zustandsvariablen bzw. Zustandsgrößen des Modells ausgegeben werden.

In gleicher Weise kann die aktuelle Maximal-Ruhespannung ermittelt werden, indem ein Prädiktionsverfahren, beispielsweise das der Druckschrift DE 10301823 A1, verwendet wird, das dem Betrieb der Batterie nachgeführt wird. Ferner kann als aktuelle Maximal-Ruhespannung die Maximal-Ruhespannung verwendet werden, die beim letzten vollgeladenen Zustand der Batterie ermittelt wurde, beispielsweise durch Messen und Integrieren oder aufgrund von Prädiktionsmodellen. Gegebenenfalls kann hierzu ein Korrekturanteil hinzukommen, der die Alterung, den Entladestrom und die Entladetemperatur berücksichtigt. Mit anderen Worten kann der Korrekturanteil die Veränderung der ursprünglichen Sollkonzentration seit dem letzten Ermitteln der Maximal-Ruhespannung berücksichtigen. Bei Verwendung eines Prädiktionsmodells zur Ermittlung der aktuellen Maximal-Ruhespannung wird vorzugsweise das selbe Prädiktionsmodell verwendet, mit dem auch die aktuelle Ruhespannung und die Minimal-Ruhespannung der Batterie bei der Betriebstemperatur ermittelt wurde.

Vorzugsweise wird die Betriebstemperatur der Batterie während des Entladungsvorgangs erfasst, der der erfindungsgemäßen Erfassung der entnehmbaren Ladungsmenge vorangeht. Bei Verwendung von Prädiktionsmodellen oder Adaptionsverfahren wird die Betriebstemperatur vorzugsweise als Eingabe-Zustandsgröße in das Modell eingebracht, woraufhin weitere Zustandsgrößen des Modells bzw. das Modell selbst (über Modellparameter) sich der eingegebenen Temperatur gemäß der physikalischen Gesetze anpassen, die von dem Modell wiedergegeben werden. Da der Entladevorgang dem erfindungsgemäßen Erfassen der entnehmbaren Ladungsmenge vorangeht, betrifft die Formulierung "bei Betriebstemperatur" den vorangehenden Entladevorgang, so dass in diesem Zusammenhang der Begriff "Betrieb" identisch mit dem Entladeprozess ist. Mit "Betrieb" ist somit in diesem Zusammenhang nicht der Prozess gemeint, der während der Erfassung der entnehmbaren Ladungsmenge oder danach stattfindet.

Die Betriebstemperatur kann mittels Temperatursensoren erfasst werden oder kann vorgesehen werden, indem andere Betriebsgrößen, beispielsweise Innenwiderstand und Ähnliches, sowie ein Modell vorgesehen werden, aus deren Kombination sich auf die Temperatur während des Entladevorgangs schließen lässt. Prinzipiell kann die Erfassung der entnehmbaren Ladungsmenge direkt auf das Betreiben der Batterie als Energiequelle (d.h. der Entladeprozess) folgen. Alternativ können zwischen dem Betreiben der Batterie als Energiequelle und dem Erfassen der entnehmbaren Ladungsmenge einige Lade- bzw. Entladezyklen liegen, soweit diese von einem verwendeten Prädiktionsmodell und einem verwendeten Adaptionsverfahren mit berücksichtigt werden.

Das Verfahren kann ausgeführt werden mittels Software, Hardware oder einer Kombination hiervon, vorzugsweise mit einer CPU und einer Software, die zumindest teilweise die Funktion des erfindungsgemäßen Verfahrens wiedergibt und ausführt. Die Hardware, beispielsweise eine CPU oder ein Mikroprozessor, ist vorzugsweise mit einem Speicher verbunden, in dem die Software gespeichert ist, die auf der CPU zur Ausführung des Verfahrens ablaufen soll. Ferner umfasst eine Vorrichtung zur Ausführung des Verfahrens vorzugsweise einen Speicher, in dem Zustandsgrößen gespeichert werden können. Schließlich umfasst eine Vorrichtung zur Ausführung des Verfahrens vorzugsweise eine Ausgabevorrichtung zur Ausgabe der entnehmbaren Ladungsmenge sowie eine Eingabeschnittstelle zur Eingabe ein oder mehrerer Messgrößen bzw. Vorgaben.

Die Erfindung kann ferner mittels eines Datenspeichers oder eines Datenprogramms umgesetzt werden, das Instruktionen umfasst, welche beim Ablauf auf einer Verarbeitungseinheit das erfindungsgemäße Verfahren umsetzen.

Vorzugsweise wird als Batterie ein Bleiakkumulator verwendet, wobei die Modelle von gegebenenfalls eingesetzten Adaptionsverfahren oder Prädiktionsmodelle die wesentlichen physikalischen Prozesse wiedergeben, die in einem Bleiakkumulator ablaufen. Grundsätzlich ist das Verfahren auch für andere Akkumulatortypen geeignet, beispielsweise Lithium-Ionenakkumulatoren, soweit das Prädiktionsmodell und das Modell des Adaptionsverfahrens Prozesse wiedergeben, die für Lithium-Ionenakkumulatoren spezifisch sind. Lithium-Ionenakkumulatoren oder andere Akkumulatorarten sind insofern für das erfindungsgemäße Verfahren anzuwenden, als dass sie einen Kapazitätsverlust bei Entladung bei niedrigen Temperaturen aufweisen und das Verhältnis der verfügbaren Kapazität zur zugehörigen Gesamtkapazität nicht von der Temperatur abhängt. Insbesondere spiegeln vorzugsweise bei der Verwendung des erfindungsgemäßen Verfahrens für Lithium-Ionenakkus die Prädiktionsmodelle oder die Modelle, die gegebenenfalls dem verwendeten Adaptionsverfahren zugrunde liegen, diese Eigenschaften wieder.

**Patentansprüche**

1. Verfahren zur temperaturkompensierten Erfassung einer entnehmbaren Ladungsmenge eines Akkumulators mit den Schritten:

   Betreiben einer Batterie als Energiequelle, wodurch die Batterie teilweise entladen wird;
   Vorsehen eines Gesamtkapazität-Schätzwerts der Batterie;
   Erfassen der entnehmbaren Ladungsmenge und Kompensieren eines Temperaturfehlers, der sich auf die entnehmbare Ladungsmenge bezieht, durch:

   Vorsehen eines Faktors, der sich aus dem Verhältnis einer ersten Ruhespannungsdifferenz zu einer zweiten Ruhespannungsdifferenz ergibt, wobei die erste Ruhespannungsdifferenz die Differenz zwischen der aktuellen Ruhespannung der Batterie und der Minimal-Ruhespannung der Batterie bei der Betriebstemperatur ist und die zweite Ruhespannungsdifferenz die Differenz zwischen einer aktuellen Maximal-Ruhespannung der Batterie und der Minimal-Ruhespannung der Batterie bei der Betriebstemperatur ist; hier ist unter Betriebstemperatur diejenige Temperatur zu verstehen, die während des Entladens der Batterie geherrscht hat;
   und
   Vorsehen der entnehmbaren Ladungsmenge als Ergebnis einer Multiplikation des Faktors mit dem Gesamtkapazität-Schätzwert.

2. Verfahren nach Anspruch 1, wobei das Verfahren umfasst: Ermitteln der aktuellen Ruhespannung der Batterie und der Minimal-Ruhespannung der Batterie bei der Betriebstemperatur mittels eines Adaptionsverfahrens, mittels eines modellgestützten Adaptionsverfahrens, mittels eines Kalman-Filters, mittels einer Look-up-Tabelle, mittels Näherungsgleichungen oder mittels eines selbstlernenden Schätzers in Form eines neuronalen Netzes oder Expertensystems.

3. Verfahren nach Anspruch 1 oder 2, wobei das Vorsehen des Gesamtkapazität-Schätzwerts umfasst: Schätzen des Gesamtkapazität-Schätzwerts mittels eines Adaptionsverfahrens, mittels eines modellgestützten Adaptionsverfahrens, mittels eines Kalman-Filters, mittels einer Look-up-Tabelle, mittels Näherungsgleichungen oder mittels eines selbstlernenden Schätzers in Form eines neuronalen Netzes oder Expertensystems.

**4.** Verfahren nach Anspruch 1, 2 oder 3, wobei das Vorsehen des Gesamtkapazität-Schätzwerts umfasst: Ermitteln der Differenz zwischen der aktuellen Maximal-Ruhespannung der Batterie und der aktuellen Minimal-Ruhespannung der Batterie und Ermitteln des Produkts einer Säurekapazität der Batterie mit der Differenz umfasst.

**5.** Verfahren nach einem der vorangehenden Ansprüche, wobei die Ermittlung der aktuellen Maximal-Ruhespannung auf einer ursprünglichen Säurekonzentration der Batterie im Neuzustand basiert und das Ermitteln der aktuellen Maximal-Ruhespannung Alterungsprozesse durch Lade- und Entlade-Gesamtenergiemengen, durch Lade- und Entlade-Stromstärken, durch Aktivmasseverlust, durch Wasserverlust, durch Sulfatierung, und/oder durch seit dem Zeitpunkt der Herstellung verstrichene Zeit mittels numerischer Modelle berücksichtigt.

**6.** Verfahren nach einem der vorangehenden Ansprüchen, wobei der Schritt des Vorsehens eines Gesamtkapazität-Schätzwerts umfasst: Vorsehen eines Ladungsprädiktors, der ein an physikalische Prozesse innerhalb der Batterie angepasstes empirisches oder mathematisches Batteriemodell umfasst, und Anwenden des Ladungsprädiktors an Betriebsparameter der Batterie.

**7.** Verfahren nach Anspruch 6, wobei das Batteriemodell als Kalmanfilter, als als selbstlernender Schätzer in Form eines neuronalen Netzes oder Expertensystems, als Look-up-Tabelle, oder als Näherungsgleichungen ausgebildet ist.

**8.** Verfahren nach einem der vorangehenden Ansprüchen, das ferner umfasst: Erfassen der Betriebstemperatur der Batterie während dem Betreiben der Batterie als elektrische Energiequelle.

**9.** Verfahren nach einem der vorangehenden Ansprüchen, wobei die betriebene Batterie ein Bleiakkumulator ist.

**Claims**

**1.** Method for the temperature-compensated detection of a quantity of charge that can be withdrawn from a rechargeable battery, comprising the following steps:

operating a battery as an energy source, as a result of which the battery is partially discharged;
providing a total capacitance estimated value of the battery;
detecting the quantity of charge that can be withdrawn and compensating for a temperature error related to the quantity of charge that can be withdrawn by:

providing a factor that results from the ratio of a first quiescent voltage difference to a second quiescent voltage difference, wherein the first quiescent voltage difference is the difference between the present quiescent voltage of the battery and the minimum quiescent voltage of the battery at the operating temperature and the second quiescent voltage difference is the difference between a present maximum quiescent voltage of the battery and the minimum quiescent voltage of the battery at the operating temperature; in this case, operating temperature is to be understood as meaning that temperature prevailing during discharge of the battery;
and
providing the quantity of charge that can be withdrawn as the result of a multiplication of the factor by the total capacitance estimated value.

**2.** Method according to Claim 1, wherein the method comprises: identifying the present quiescent voltage of the battery and the minimum quiescent voltage of the battery at the operating temperature by means of an adaptation method, by means of a model-aided adaptation method, by means of a Kalman filter, by means of a look-up table, by means of approximation equations or by means of a self-learning estimator in the form of a neural network or expert system.

**3.** Method according to Claim 1 or 2, wherein the provision of the total capacitance estimated value comprises: estimating the total capacitance estimated value by means of an adaptation method, by means of a model-aided adaptation method, by means of a Kalman filter, by means of a look-up table, by means of approximation equations or by means of a self-learning estimator in the form of a neural network or expert system.

**4.** Method according to Claim 1, 2 or 3, wherein the provision of the total capacitance estimated value comprises: identifying the difference between the present maximum quiescent voltage of the battery and the present minimum quiescent voltage of the battery and comprises identifying the product of an acid capacity of the battery and the difference.

5. Method according to one of the preceding claims, wherein the identification of the present maximum quiescent voltage is based on an original acid concentration of the battery in the new state and the identification of the present maximum quiescent voltage takes into account ageing processes due to total charging and discharging amounts of energy, due to charging and discharging current intensities, due to active material loss, due to water loss, due to sulphation and/or due to time elapsed since the point of production by means of numerical models.

6. Method according to one of the preceding claims, wherein the step of providing a total capacitance estimated value comprises: providing a charge predictor, which comprises an empirical or mathematical battery model adapted to physical processes within the battery, and applying the charge predictor to operating parameters of the battery.

7. Method according to Claim 6, wherein the battery model is designed as a Kalman filter, as as a self-learning estimator in the form of a neural network or expert system, as a look-up table or as approximation equations.

8. Method according to one of the preceding claims, which further comprises: detecting the operating temperature of the battery during operation of the battery as an electrical energy source.

9. Method according to one of the preceding claims, wherein the operated battery is a rechargeable lead-acid battery.


**Revendications**

1. Procédé de détection avec compensation de température d'une quantité de charge pouvant être prélevée d'un accumulateur, comprenant les étapes suivantes :

   exploitation d'une batterie en tant que source d'énergie, la batterie étant ainsi en partie déchargée ;
   prévision d'une valeur estimée de capacité totale de la batterie ;
   détection d'une quantité de charge pouvant être prélevée et compensation d'une erreur de température qui se rapporte à la quantité de charge pouvant être prélevée en :

      prévoyant un facteur qui est obtenu du rapport entre une première différence de tension à vide et une deuxième différence de tension à vide, la première différence de tension à vide étant la différence entre la tension à vide actuelle de la batterie et la tension à vide minimale de la batterie à la température de service et la deuxième différence de tension à vide étant la différence entre une tension à vide maximale actuelle de la batterie et la tension à vide minimale de la batterie à la température de service ;
      la température de service désigne ici la température qui régnait pendant la décharge de la batterie ; et
      prévoyant une quantité de charge pouvant être prélevée en tant que résultat d'une multiplication du facteur par la valeur estimée de capacité totale.

2. Procédé selon la revendication 1, le procédé comprenant : détermination de la tension à vide actuelle de la batterie et de la tension à vide minimale de la batterie à la température de service au moyen d'un procédé d'adaptation, au moyen d'un procédé d'adaptation assisté par modèle, au moyen d'un filtre de Kalman, au moyen d'une table de conversion, au moyen d'équations d'approximation ou au moyen d'un dispositif d'estimation à autoapprentissage sous la forme d'un réseau neuronal ou d'un système expert.

3. Procédé selon la revendication 1 ou 2, la prévision de la valeur estimée de capacité totale comprenant : estimation de la valeur estimée de capacité totale au moyen d'un procédé d'adaptation, au moyen d'un procédé d'adaptation assisté par modèle, au moyen d'un filtre de Kalman, au moyen d'une table de conversion, au moyen d'équations d'approximation ou au moyen d'un dispositif d'estimation à autoapprentissage sous la forme d'un réseau neuronal ou d'un système expert.

4. Procédé selon la revendication 1, 2 ou 3, la prévision de la valeur estimée de capacité totale comprenant : détermination de la différence entre la tension à vide maximale actuelle de la batterie et la tension à vide minimale actuelle de la batterie et comprend détermination du produit d'une capacité d'acide de la batterie avec la différence.

**5.** Procédé selon l'une des revendications précédentes, la détermination de la tension à vide maximale actuelle se basant sur une concentration d'acide initiale de la batterie à l'état neuf et la détermination de la tension à vide maximale actuelle tenant compte, au moyen de modèles numériques, des processus de vieillissement par des quantités d'énergie totales de charge et de décharge, par des intensités de courant de charge et de décharge, par des pertes à la masse active, par des pertes d'eau, par sulfatage et/ou par un temps écoulé depuis le moment de la fabrication.

**6.** Procédé selon l'une des revendications précédentes, l'étape de prévision d'une valeur estimée de capacité totale comprenant : prévision d'un prédicteur de charge qui comprend un modèle de batterie empirique ou mathématique adapté aux processus physiques à l'intérieur de la batterie, et utilisation du prédicteur de charge sur les paramètres de fonctionnement de la batterie.

**7.** Procédé selon la revendication 6, le modèle de batterie étant réalisé en tant que filtre de Kalman, en tant que en tant que dispositif d'estimation à autoapprentissage sous la forme d'un réseau neuronal ou d'un système expert, en tant que table de conversion ou en tant qu'équations d'approximation.

**8.** Procédé selon l'une des revendications précédentes, comprenant en outre : détection de la température de fonctionnement de la batterie pendant l'exploitation de la batterie en tant que source d'énergie.

**9.** Procédé selon l'une des revendications précédentes, la batterie exploitée étant un accumulateur au plomb.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10236958 A1
- DE 10232251 A1
- DE 10301823 A1
- WO 03005052 A